# FASCICULE DE BREVET EUROPEEN

(11) **EP 4 383 552 B1**
(45) Date de publication et mention de la délivrance du brevet: **04.11.2026**
(21) Numéro de dépôt: 23208911.0
(22) Date de dépôt: 09.11.2023
(51) Int. Cl.: H02P 1/02, H02P 8/02, H02P 8/08

(54) **CIRCUIT ÉLECTRONIQUE DE COMMANDE D'UN MOTEUR PAS-À-PAS CAPABLE DE DÉTECTER UN CHAMP MAGNÉTIQUE EXTÉRIEUR, MOUVEMENT ÉLECTROMAGNÉTIQUE, MONTRE ET PROCÉDÉ ASSOCIÉ**
ELEKTRONISCHE STEUERSCHALTUNG FÜR EINEN SCHRITTMOTOR, DIE EIN EXTERNES MAGNETFELD ERFASSEN KANN, ELEKTRONISCHE BEWEGUNG, UHR UND ZUGEHÖRIGES VERFAHREN
ELECTRONIC CONTROL CIRCUIT FOR A STEP MOTOR CAPABLE OF DETECTING AN EXTERNAL MAGNETIC FIELD, ELECTROMAGNETIC MOVEMENT, WATCH, AND ASSOCIATED METHOD

(30) Priorité: 06.12.2022 EP 22211700; 16.12.2022 EP 22214282
(43) Date de publication de la demande: 12.06.2024
(73) Titulaire: ETA SA Manufacture Horlogère Suisse, 2540 Grenchen (CH)
(72) Inventeur: BERTHOUD, Joerg, 2613 Villeret (CH)
(74) Mandataire: ICB SA

(56) Documents cités:
- CN-A- 110 320 790

## Description

### Domaine technique de l'invention

La présente invention concerne un circuit de commande d'un moteur pas-à-pas agencé de manière à pouvoir détecter un champ magnétique extérieur au moteur et présent dans l'environnement de ce moteur.

En particulier, le moteur pas-à-pas est un moteur horloger, notamment du type Lavet, qui est incorporé dans un mouvement électromécanique formant une montre électronique avec un affichage analogique.

### Arrière-plan technologique

Le document US 11,175,632 décrit une montre électromécanique comprenant un moteur pas-à-pas du type Lavet, ayant un rotor à aimant permanent bipolaire et une bobine montée sur un circuit magnétique formé par le stator, ce stator comprenant une ouverture circulaire pour l'aimant et définissant deux isthmes diamétralement opposés en périphérie de l'ouverture, ces deux isthmes séparant deux pôles du stator guidant un flux magnétique engendré par la bobine au travers de l'ouverture.

Le moteur est associé à un circuit de commande qui gère l'alimentation de la bobine de sorte à fournir à cette bobine, pour entraîner en rotation le rotor, des séries d'impulsions électriques, chaque série présentant des impulsions électriques de même polarité et étant prévue pour effectuer un pas moteur, les séries ayant alternativement une première polarité et une deuxième polarité opposées. En fonction du moment de force nécessaire pour effectuer chaque pas moteur ou d'autres contraintes appliquées au rotor ou également de perturbations s'exerçant sur le moteur, les impulsions électriques présentent au sein des séries et/ou entre les séries des durées variables. Cette technique est connue et on parle de modulation de largeur d'impulsion (`PWM' - `Pulse Width Modulation' en anglais). On observe aussi que le nombre d'impulsions électriques dans une série pour effectuer un pas moteur varie en fonction des événements physiques mentionnés ci-avant.

Le document US 11,175,632 enseigne qu'un champ magnétique extérieur, orienté selon la direction définie par les deux pôles du stator, influence deux paramètres des séries d'impulsions électriques qui varient en fonction de la polarité de ces séries. Plus particulièrement, on observe que le nombre d'impulsions électriques et conjointement la durée maximale de ces impulsions électriques par série varient en fonction de la polarité en présence dudit champ magnétique (étant entendu que ce champ magnétique présente une intensité propre à engendrer une perturbation dans le fonctionnement du moteur au moins dans un mode donné, notamment un mode d'entraînement rapide du rotor). Ainsi, il est proposé de détecter la présence d'un champ magnétique extérieur perturbateur en se basant sur une comparaison soit du nombre d'impulsions, soit de la durée maximale de ces impulsions entre des séries présentant des polarités opposées, c'est-à-dire des polarités positives et négatives.

Cette technique est relativement complexe à mettre en œuvre, comme le montre la description du document US susmentionné, et elle n'est possible que dans le cas d'une commande du moteur avec la technique de modulation de largeur d'impulsions.

A noter que le document US 11,165,376 donne un enseignement technique qui est similaire à celui du document US 11,175,632. Ce dernier document, exposé ci-avant, traite le cas d'un mouvement électromécanique comprenant trois moteurs, avec un moteur entrainant l'aiguille des secondes et un autre moteur entrainant l'aiguille des heures et l'aiguille des minutes, alors que le premier document concerne un mouvement électromécanique muni d'un seul moteur entrainant l'ensemble de ces aiguilles.

### Résumé de l'invention

La présente invention a pour objectif de proposer un circuit électronique de commande d'un moteur du type pas-à-pas comprenant un circuit de détection d'un champ magnétique extérieur qui soit adapté à une commande du moteur générant des impulsions d'entraînement du moteur du type continu, c'est-à-dire à tension constante pour toute la durée de chaque impulsion d'entraînement du rotor de ce moteur (donc sans 'PWM').

La présente invention a aussi pour objectif de proposer un procédé de détection d'un champ magnétique extérieur, via un circuit de commande évolué pour un moteur pas-à-pas, qui soit efficace et relativement peu complexe, en exploitant un phénomène physique différent que celui enseigné dans l'art antérieur et mis en lumière lors du développement ayant conduit à la présente invention.

La présente invention concerne un circuit électronique de commande d'un moteur du type pas-à-pas, ce moteur comprenant un rotor à aimant permanent bipolaire, présentant un axe d'aimantation perpendiculaire à l'axe de rotation de ce rotor, et un stator définissant un circuit magnétique et une ouverture formant un logement pour l'aimant permanent. Le stator définit aussi deux isthmes en périphérie de l'ouverture, lesquels sont diamétralement opposés selon une première direction perpendiculaire à l'axe de rotation, et deux positions de repos pour le rotor dans lesquelles l'aimant permanent est orienté selon une deuxième direction, décalée angulairement relativement à la première direction, respectivement dans les deux sens. L'aimant permanent génère dans les deux positions de repos un premier flux magnétique traversant les deux isthmes respectivement dans les deux sens, une première position de repos correspondant par définition à un sens positif et la seconde position de repos correspondant à un sens négatif du premier flux magnétique. Le moteur comprend en outre une bobine montée sur le circuit magnétique de manière à pouvoir générer, lorsqu'elle est alimentée par une impulsion électrique positive ou une impulsion électrique négative, un deuxième flux magnétique traversant les deux isthmes respectivement dans ledit sens positif ou ledit sens négatif. Le circuit électronique de commande comprend des moyens de détermination de la position du rotor au repos, parmi lesdites première et seconde positions de repos, et un générateur d'impulsions électriques associé à une source d'alimentation électrique et agencé pour pouvoir fournir sélectivement à la bobine des impulsions électriques positives et négatives. De plus, le circuit électronique de commande comprend un circuit de détection d'un champ magnétique extérieur formé par un circuit de mesure dudit courant électrique, un circuit de comparaison du courant électrique mesuré avec un courant de référence, un circuit de mesure du temps permettant de mesurer un temps de montée entre le déclenchement d'une desdites impulsions électriques et l'instant suivant où le courant électrique circulant dans la bobine atteint le courant de référence, et un circuit de traitement du temps de montée qui est agencé pour pouvoir déterminer si le temps de montée mesuré indique la présence d'un certain champ magnétique extérieur traversant les deux isthmes.

Selon deux variantes principales, le circuit de traitement du temps de montée est agencé pour pouvoir déterminer, au moins dans une plage de valeurs utile, soit approximativement une intensité du champ magnétique extérieur ou de son flux traversant, le cas échéant, les deux isthmes, soit si l'intensité dudit champ magnétique extérieur ou de son flux traversant, le cas échéant, les deux isthmes est supérieure à une valeur de référence.

Selon une variante particulière, le circuit de traitement du temps de montée est agencé pour pouvoir déterminer, au moins dans la plage de valeurs utile, si l'intensité du champ magnétique extérieur ou de son flux traversant, le cas échéant, les deux isthmes est situé dans une plage de valeurs spécifique parmi une pluralité de plages de valeurs spécifiques données qui se succèdent.

Selon un mode de réalisation avantageux, le circuit de traitement du temps de montée est agencé pour pouvoir également déterminer le sens du champ magnétique extérieur traversant, le cas échéant, les deux isthmes.

Selon un mode de réalisation préféré, le circuit de commande est agencé, pour détecter la présence d'un certain champ magnétique extérieur, de manière à générer une impulsion électrique en contre-phase relativement à la position de repos du rotor, à savoir une impulsion électrique négative lorsque le rotor est dans la position de repos positive et une impulsion électrique positive lorsque le rotor est dans la position de repos négative, de sorte que la détection du champ magnétique extérieur ne puisse pas engendrer une avance d'un pas du rotor.

Grâce aux caractéristiques de l'invention, il est possible de détecter la présence d'un champ magnétique extérieur sur la base d'un temps de montée du courant électrique dans la bobine du moteur, jusqu'à une durée de référence donnée, suite au déclenchement d'une impulsion électrique (impulsion de détection), laquelle peut être relativement courte. Les conditions à cette détection sont relatives à la position de repos dans laquelle se trouve le rotor lors du déclenchement de l'impulsion de détection et à la direction ainsi qu'au sens du champ électrique extérieur relativement au stator, comme ceci apparaîtra clairement dans la description détaillée de l'invention qui suit.

L'invention concerne encore un mouvement électromécanique comprenant un moteur du type pas-à-pas et un circuit de commande de ce moteur agencé selon la présente invention, le moteur comprenant un rotor muni d'un aimant permanent bipolaire (par la suite aussi nommé 'aimant permanent' ou 'aimant'), présentant un axe d'aimantation perpendiculaire à l'axe de rotation de ce rotor, et un stator définissant un circuit magnétique et une ouverture formant un logement pour l'aimant permanent. Le stator définit deux isthmes en périphérie de l'ouverture, lesquels sont diamétralement opposés selon une première direction perpendiculaire à l'axe de rotation, et deux positions de repos pour le rotor dans lesquelles l'aimant permanent est orienté selon une deuxième direction, décalée angulairement relativement à la première direction, respectivement dans les deux sens. L'aimant permanent génère dans les deux positions de repos un premier flux magnétique traversant les deux isthmes respectivement dans les deux sens, une première position de repos correspondant par définition à un sens positif et la seconde position de repos correspondant à un sens négatif du premier flux magnétique. Le moteur comprend en outre une bobine montée sur le circuit magnétique de manière à pouvoir générer, lorsqu'elle est alimentée par une impulsion électrique positive ou une impulsion électrique négative, un deuxième flux magnétique traversant les deux isthmes respectivement dans ledit sens positif ou ledit sens négatif. L'invention concerne également une montre incorporant un mouvement électromécanique selon la présente invention.

De plus, l'invention concerne aussi un procédé de détection d'un champ magnétique extérieur dans lequel se trouve un moteur du type pas-à-pas, notamment un moteur horloger, commandé par un circuit électronique de commande selon la présente invention.

### Brève description des figures

L'invention sera décrite ci-après de manière plus détaillée à l'aide des dessins annexés, donnés à titre d'exemples nullement limitatifs, dans lesquels :

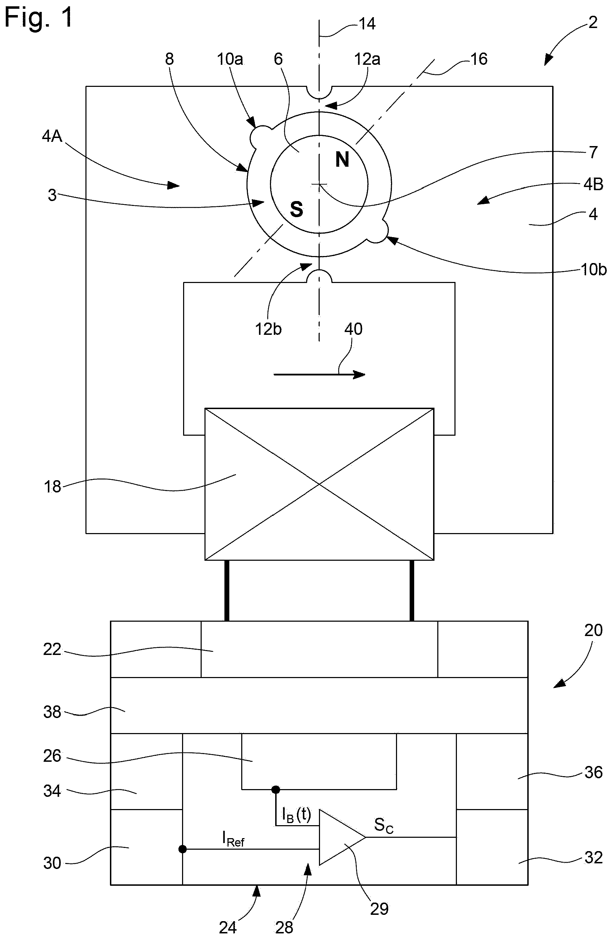

- la Figure 1 est une représentation schématique d'un moteur horloger, du type pas-à-pas et monophasé, et d'un mode de réalisation général d'un circuit de commande de ce moteur selon l'invention ;
- la Figure 2 est une vue schématique du moteur horloger de la Figure 1 montrant schématiquement le flux magnétique de l'aimant du rotor au niveau des deux isthmes du stator ;
- la Figure 3 est un graphe donnant la courbe du flux magnétique de l'aimant du rotor dans les deux isthmes du stator en fonction de la position angulaire de l'aimant ;
- la Figure 4 est une vue schématique du moteur horloger de la Figure 1 montrant schématiquement le flux magnétique généré par la bobine lors d'une impulsion électrique positive ;
- la Figure 5 est un graphe donnant les deux courbes du flux magnétique généré par le courant électrique dans la bobine, négatif et positif, respectivement dans les deux isthmes du stator et dans le noyau de la bobine ;
- la Figure 6 est une vue schématique du moteur horloger de la Figure 1 montrant schématiquement la circulation d'un champ magnétique extérieur dans le stator, ce champ magnétique extérieur se propageant selon une direction générale dans le plan du stator et orthogonale à la direction d'alignement des deux isthmes et dans le sens positif ;
- la Figure 7 est une vue schématique du moteur horloger de la Figure 1 similaire à celle de la Figure 6, mais pour un sens négatif du champ magnétique extérieur selon la direction générale susmentionnée ;
- la Figure 8 est un graphe donnant la courbe du flux magnétique extérieur passant dans les deux isthmes du stator en fonction de l'intensité du champ magnétique extérieur, en l'absence des autres flux magnétiques ;
- les Figures 9A à 9D montrent quatre courbes de l'évolution du courant électrique dans la bobine, suite au déclenchement d'une impulsion électrique, en fonction de diverses conditions pour la position de repos de l'aimant et la polarité de l'impulsion électrique, en l'absence de champ magnétique extérieur ;
- les Figures 10A à 10D montrent respectivement quatre courbes de l'évolution du courant électrique dans la bobine, suite au déclenchement d'une impulsion électrique, en fonction de diverses conditions pour la position de repos de l'aimant et la polarité de l'impulsion électrique, en présence d'un champ magnétique extérieur de sens positif, tel que représenté en Figure 6 ;
- les Figures 11A & 11B sont deux graphes donnant des courbes de l'évolution du courant électrique dans la bobine, suite au déclenchement d'une impulsion électrique, pour l'aimant dans sa position de repos positive et une l'impulsion électrique en phase (polarité positive) respectivement pour les deux sens, négatif et positif, d'un champ magnétique extérieur selon les Figures 6 & 7, en fonction de diverses intensités de ce champ magnétique extérieur ;
- les Figures 12A & 12B sont deux graphes donnant des courbes de l'évolution du courant électrique dans la bobine, suite au déclenchement d'une impulsion électrique, pour l'aimant dans sa position de repos positive et une l'impulsion électrique en contre-phase (polarité négative) respectivement pour les deux sens, négatif et positif, d'un champ magnétique extérieur selon les Figures 6 & 7, en fonction de diverses intensités de ce champ magnétique extérieur ;
- la Figure 13 est un tableau donnant l'évolution temporelle de la montée du courant électrique dans la bobine, suite au déclenchement d'une impulsion électrique, dans les diverses configurations magnétiques possibles au niveau des deux isthmes du stator, pour un champ magnétique extérieur nul ou faible et un champ magnétique extérieur relativement fort ;
- la Figure 14 est un tableau donnant des durées pour le temps de montée du courant électrique jusqu'à une intensité de référence, lors du déclenchement d'une impulsion électrique, en fonction de la position de repos de l'aimant, de la polarité de l'impulsion électrique et de diverses intensités du flux magnétique extérieur dans les deux sens ;
- la Figure 15 est un diagramme exposant un procédé de détection d'un certain champ magnétique extérieur pour une impulsion électrique en phase ; et
- la Figure 16 est un diagramme exposant un procédé de détection d'un certain champ magnétique extérieur pour une impulsion électrique en contre-phase.

### Description détaillée de l'invention

En référence aux Figures annexées, on décrira un mode de réalisation d'un circuit électronique de commande 20 d'un moteur 2 du type pas-à-pas, notamment d'un moteur horloger, et on exposera en détails le phénomène physique utilisé par un circuit de détection 24 agencé pour détecter un champ magnétique extérieur environnant le moteur, ce circuit de détection étant incorporé dans le circuit électronique de commande, ainsi que le procédé de détection d'un champ magnétique extérieur mis en œuvre par ce circuit de détection.

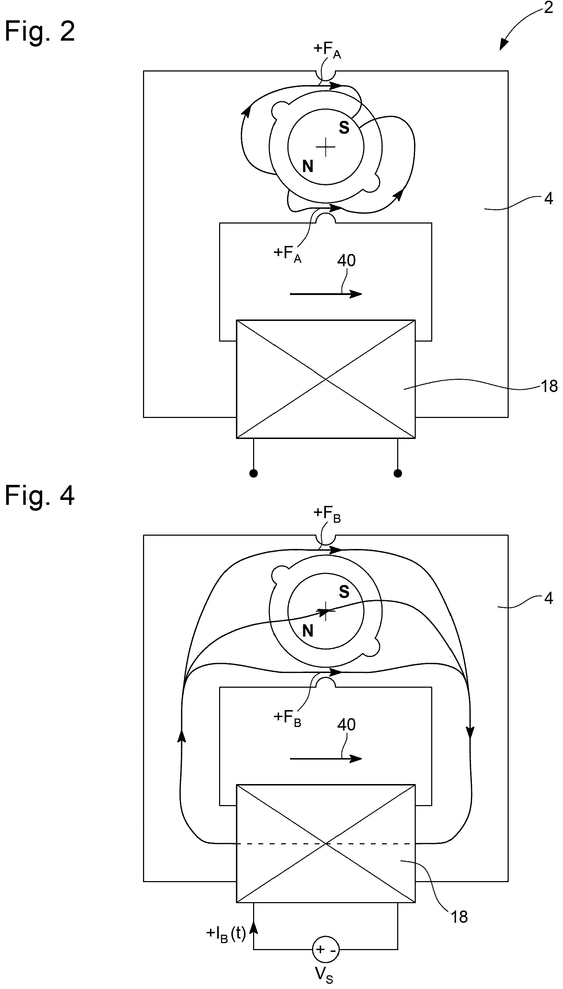

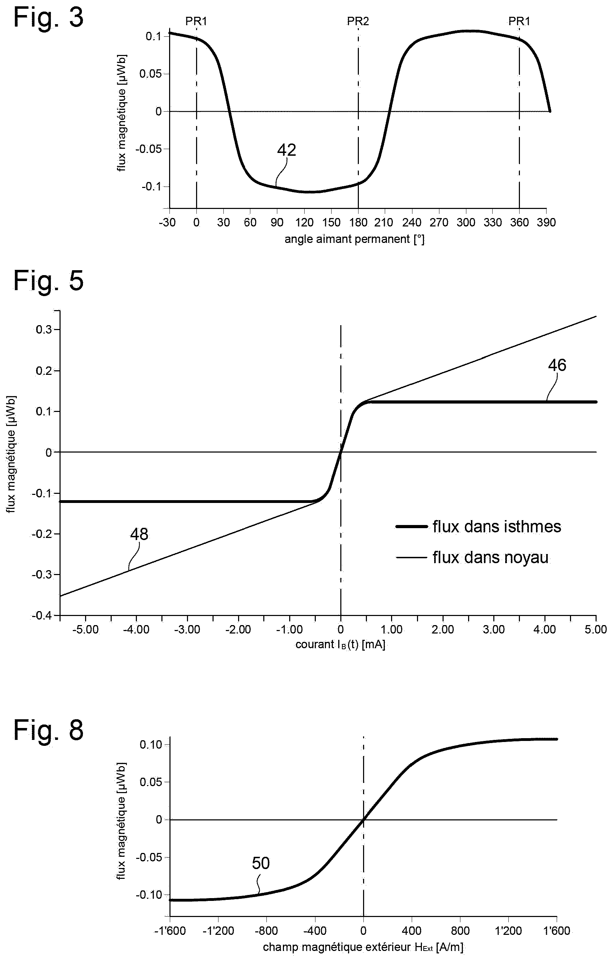

Le moteur 2 comprend un rotor 3 muni d'un aimant permanent bipolaire 6, présentant un axe d'aimantation perpendiculaire à l'axe de rotation 7 de ce rotor, et un stator 4 définissant un circuit magnétique et une ouverture 8 formant un logement pour l'aimant permanent 6. Le stator définit aussi deux isthmes 12a & 12b, diamétralement opposés selon une première direction 14 perpendiculaire à l'axe de rotation 7, et deux positions de repos stables pour le rotor dans lesquelles l'aimant permanent, à savoir son axe d'aimantation, est orienté selon une deuxième direction 16, décalée angulairement relativement à la première direction 14, respectivement dans les deux sens. Les deux positions de repos sont classiquement déterminées par deux encoches 10a & 10b prévues au bord de l'ouverture 8 et diamétralement opposées. L'aimant permanent 6 génère dans chacune de ses deux positions de repos un premier flux magnétique F_{A} traversant les deux isthmes respectivement dans les deux sens. Les isthmes 12a & 12b sont agencés de manière qu'un flux magnétique que traverse l'un ou l'autre isthme traverse cet isthme principalement selon une troisième direction 40 (représentée à la Fig.2) qui est orthogonale à la première direction 14. Une première position de repos, dite aussi position de repos positive, correspond à un sens positif du premier flux magnétique F_{A} dans les deux isthmes, noté + F_{A} (Fig.2), et la seconde position de repos, dite aussi position de repos négative, correspond à un sens négatif du premier flux magnétique F_{A} dans les deux isthmes, noté -F_{A}. La Figure 3 est un graphe donnant la courbe 42 du flux magnétique F_{A} en fonction de la position angulaire (sens antihoraire) de l'aimant permanent 6. La position de repos positive PR1 de l'aimant permanent, et donc du rotor, est à 0° et la position de repos négative PR2 est à 180°. On observe que le flux magnétique de l'aimant permanent sature dans une certaine mesure les deux isthmes du stator dans les deux positions de repos. Sans saturation magnétique, la courbe serait sensiblement sinusoïdale.

Le moteur 2 comprend en outre une bobine 18 montée sur le circuit magnétique de manière à pouvoir générer, lorsqu'elle est alimentée par une impulsion électrique positive + I_{B}(t) ou par une impulsion électrique négative - I_{B}(t), un deuxième flux magnétique F_{B} traversant les deux isthmes, dans la variante représentée principalement selon la troisième direction 40, respectivement dans ledit sens positif +F_{B} (Fig. 4) et ledit sens négatif -Fs. La Figure 5 donne la courbe 46 du flux magnétique F_{B}(t) généré par la bobine 18 dans les deux isthmes 12a & 12b, en l'absence du flux magnétique de l'aimant du rotor et d'autres flux magnétiques, en fonction de l'intensité du courant électrique I_{B}(t) dans la bobine, ainsi que la courbe 48 du flux magnétique correspondant qui se propage dans le noyau de la bobine. On observe que le flux magnétique dans le noyau augmente sensiblement linéairement en fonction de l'augmentation de l'intensité du courant électrique alors que le flux magnétique dans les isthmes sature rapidement, déjà environ à 0.05 mA. On comprend des Fig. 3 et 5 que le flux magnétique généré par la bobine dans le stator est rapidement supérieur à celui généré par l'aimant permanent. Ceci a pour conséquence que le flux magnétique F_{B} de la bobine 16 impose, après un certain délai suite au déclenchement d'une impulsion électrique, le sens du flux magnétique dans les deux isthmes, lequel arrive rapidement à saturation (valeur d'environ 100 nWb dans l'exemple donné) même lorsque le flux magnétique de l'aimant F_{A} est de sens opposé à celui de la bobine dans les deux isthmes.

Le circuit électronique de commande 20 comprend des moyens de détermination de la position du rotor au repos, parmi lesdites première et seconde positions de repos, et un générateur 22 d'impulsions électriques associé à une source d'alimentation électrique et agencé pour pouvoir fournir sélectivement à la bobine des impulsions électriques positives + I_{B}(t) et des impulsions électriques négatives - I_{B}(t), notamment sous une tension entre environ 1 V et 3 V. Le générateur 22 est agencé pour pouvoir fournir des impulsions électriques d'entraînement en rotation du rotor (impulsions motrices), ainsi que des impulsions électriques de détection (impulsions de détection), à savoir de détection d'un champ magnétique extérieur H_{Ext}, comme ceci sera exposé plus en détails par la suite. Un circuit de gestion 38 gère notamment la génération des impulsions électriques fournies à la bobine. On notera que des impulsions électriques motrices peuvent aussi former conjointement des impulsions électriques de détection. Sans autre qualificatif associé au terme `impulsion électrique', on comprend dans le présent texte des impulsions électriques de détection (impulsions de détection). Les moyens de détermination de la position de repos du rotor, positive ou négative, sont connus de la personne du métier et généralement prévus dans les circuits de commande des moteurs horlogers pas-à-pas. Le circuit électronique de commande 20 comprend en outre le circuit 24 de détection d'un champ magnétique extérieur H_{Ext} associé au circuit de gestion 38 et formé par :
- un circuit 26 de mesure de l'intensité I_{B}(t) du courant électrique circulant dans la bobine ;
- un circuit 28 de comparaison de l'intensité du courant électrique mesuré avec un courant de référence I_{Ref} ;
- un circuit 32 de mesure du temps permettant de mesurer un temps de montée T_{M}, entre le déclenchement de chacune des impulsions électriques de détection et l'instant suivant où l'intensité I_{B}(t) du courant électrique circulant dans la bobine atteint le courant de référence I_{Ref} ; et
- un circuit 36 de traitement du temps de montée qui est agencé pour pouvoir déterminer si le temps de montée T_{M} mesuré indique la présence, lors de l'impulsion électrique de détection considérée, d'un certain champ magnétique extérieur H_{Ext} traversant les isthmes 12a & 12b selon la troisième direction 40 (ceci découle de la configuration de ces deux isthmes qui définissent deux rétrécissements, pour le flux magnétique dans le stator, orientés tangentiellement à l'ouverture 8 qui est globalement circulaire).

En particulier, le circuit de comparaison 28 comprend un comparateur 29 qui reçoit en entrée, suite au déclenchement d'une impulsion électrique de détection, l'intensité I_{B}(t) du courant électrique dans la bobine, laquelle est fournie par le circuit de mesure 26, et le courant de référence I_{Ref}, fourni par une mémoire 30, et qui fournit en sortie un signal de comparaison Sc indiquant si l'intensité I_{B}(t) est supérieure à la valeur de référence I_{Ref}. Le circuit de détection 24 comprend une base de temps 34 qui fournit un signal de cadencement relativement élevé, par exemple égal ou supérieur à 500 kHz, pour d'une part permettre de suivre en temps quasi réel l'intensité I_{B}(t) du courant électrique mesuré et, d'autre part, de déterminer précisément le temps de montée T_{M} par le circuit de mesure 32 (compteur temporel 32).

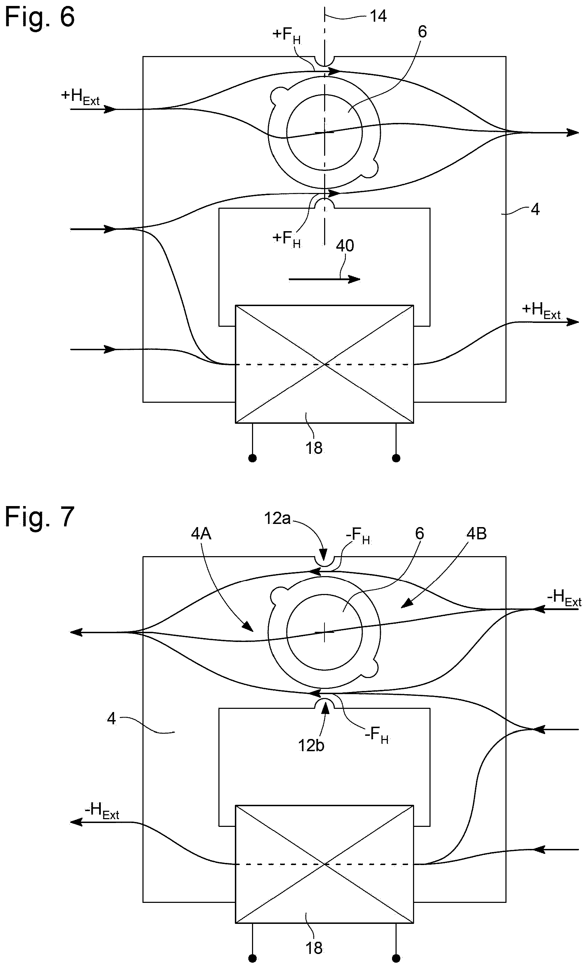

Les Figures 6 et 7 représentent un champ magnétique extérieur H_{Ext} dont la composante principale se propage dans le plan général du stator selon la direction 40, c'est-à-dire selon une direction orthogonale à la direction 14 d'alignement des deux isthmes 12a & 12b, respectivement dans un sens positif, générant un flux magnétique + F_{H} dans les deux isthmes, et dans un sens négatif, générant un flux magnétique - F_{H} dans les deux isthmes. Ce qui importe dans le procédé de détection du champ magnétique extérieur H_{Ext}, c'est le flux magnétique F_{H}, nommé `flux magnétique extérieur', qui passe dans les deux isthmes, à savoir qui traverse ces deux isthmes entre deux parties polaires 4A et 4B du stator 4. La Figure 8 donne la courbe 50 du flux magnétique F_{H} dans les deux isthmes du stator en fonction de l'intensité du champ magnétique extérieur H_{Ext} dans le sens négatif et le sens positif, en l'absence d'autres champs magnétiques. On observe que le flux magnétique extérieur sature les deux isthmes lorsque l'intensité du champ magnétique extérieur augmente. L'intensité du champ magnétique extérieur H_{Ext} qui est considérée dans le mode de réalisation décrit ici est de l'ordre 1'000 A/m, soit jusqu'à environ 2'000 A/m. Toutefois, le procédé de détection selon l'invention n'est pas limité à des champs magnétiques extérieurs inférieurs à cette valeur de 2'000 A/m.

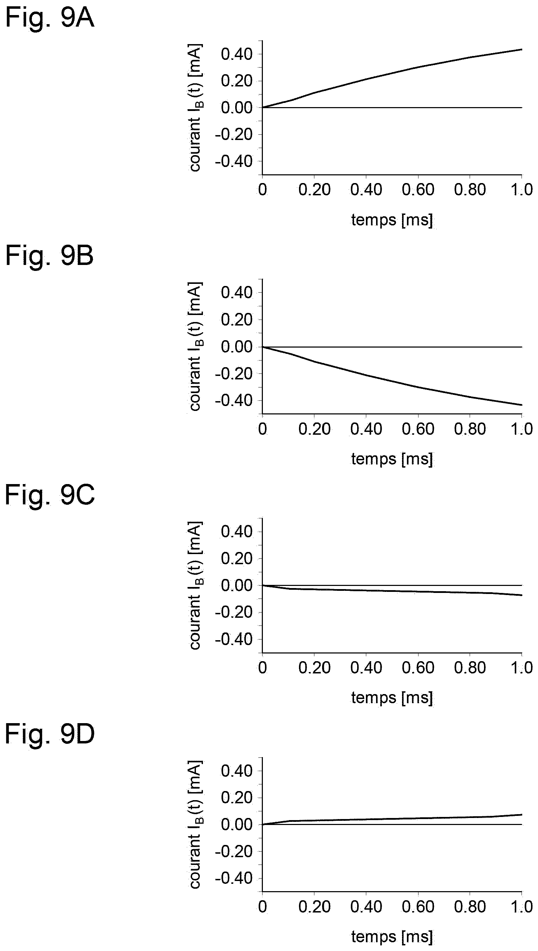

Les Figures 9A à 9D montrent quatre courbes de l'évolution temporelle du courant électrique dans la bobine, suite au déclenchement d'une impulsion électrique de détection, respectivement pour une position de repos positive et une position de repos négative du rotor et, pour chacune de ces deux positions de repos, une impulsion électrique positive et une impulsion électrique négative, sans la présence d'un champ magnétique extérieur dans les isthmes. Dans le cadre du développement d'un circuit électronique de commande d'un moteur du type pas-à-pas ayant conduit à la présente invention, l'inventeur a fait les observations exposées ci-après. Lorsque le flux F_{A} de l'aimant permanent dans les deux isthmes présente un même sens que le flux F_{B} de la bobine dans ces deux isthmes, soit position de repos positive et courant électrique positif (Fig. 9A), soit position de repos négative et courant électrique négatif (Fig. 9B), le courant électrique I_{B}(t) augmente relativement rapidement suite au déclenchement d'une impulsion électrique (on parlera d'une augmentation rapide du courant électrique et d'un temps de montée T_{M} à un courant de référence I_{Ref} qui est rapide). Par contre, lorsque le flux F_{A} de l'aimant permanent dans les deux isthmes présente un sens opposé à celui du flux F_{B} de la bobine dans ces deux isthmes, soit position de repos positive et courant électrique négatif (Fig. 9C), soit position de repos négative et courant électrique positif (Fig. 9D), le courant électrique augmente relativement lentement suite au déclenchement d'une impulsion électrique (on parlera d'une augmentation lente du courant électrique et d'un temps de montée T_{M} à un courant de référence I_{Ref} qui est lent).

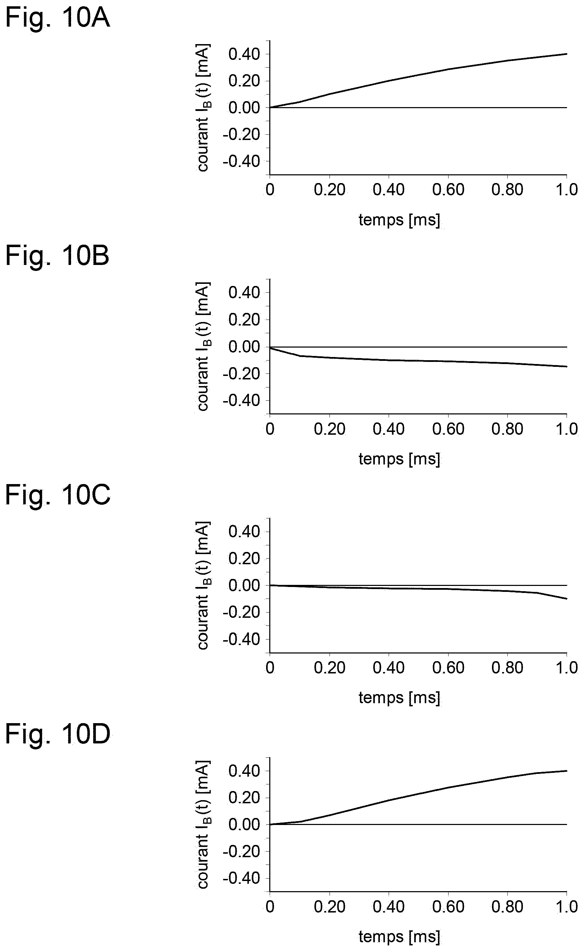

Aux Figures 10A à 10D sont données quatre courbes de l'évolution temporelle du courant électrique I_{B}(t) dans la bobine, suite au déclenchement d'une impulsion de détection, respectivement pour les quatre configurations des Fig. 9A à 9D et un champ magnétique extérieur H_{Ext} positif relativement fort, soit + H_{EXT} = + 1'600 A/m, engendrant un flux magnétique extérieur relativement fort dans les deux isthmes et positif, soit + F_{H}. On observe que lorsque le courant électrique et le champ magnétique extérieur sont tous deux de même signe, c'est-à-dire que le flux magnétique F_{B} de la bobine et le flux magnétique extérieur F_{H} présentent un même sens (ici positif), le courant électrique I_{B}(t) augmente relativement rapidement suite au déclenchement d'une impulsion électrique, indépendamment du fait que l'aimant permanent 6 soit dans sa position de repos positive ou négative. Par contre, lorsque le courant électrique et le champ magnétique extérieur ont des signes opposés, c'est-à-dire que le flux magnétique F_{B} de la bobine (ici négatif) et le flux magnétique extérieur F_{H} (ici positif) présentent des sens opposés, le courant électrique I_{B}(t) augmente relativement lentement suite au déclenchement d'une impulsion électrique, indépendamment du fait que l'aimant permanent soit dans sa position de repos positive ou négative.

On constate donc qu'il y a un changement dans l'évolution du courant électrique I_{B}(t) circulant dans la bobine, suite au déclenchement d'une impulsion électrique fournie à cette bobine, en présence d'un flux magnétique extérieur F_{H} relativement fort traversant les deux isthmes du stator 4 et ayant un sens opposé au flux magnétique F_{A} généré par l'aimant permanent 6 du rotor 3, donc lorsque le champ magnétique extérieur est positif et l'aimant permanent / le rotor est dans la position de repos négative (Figures 10B et 10D) ou que le champ magnétique extérieur est négatif et l'aimant permanent / le rotor est dans la position de repos positive. Plus particulièrement, lorsque l'aimant permanent du rotor est en phase avec l'impulsion électrique de détection (cas correspondant à un flux d'aimant F_{A} de même sens / signe que le flux magnétique F_{B} engendré par la bobine), l'intensité I_{B}(t) du courant électrique augmente rapidement sans champ magnétique extérieur H_{Ext} mais elle augmente lentement en présence d'un champ magnétique extérieur engendrant un flux magnétique extérieur F_{H} relativement fort et de sens / signe opposé à celui de l'aimant du rotor. On a donc un temps de montée T_{M} pour le courant électrique I_{B}(t) qui devient long en présence d'un champ magnétique extérieur H_{EXT} relativement fort avec les conditions susmentionnées, car la montée du courant électrique I_{B}(t) dans ces conditions passe de 'rapide' à 'lente'.

Au contraire, lorsque l'aimant permanent du rotor est en contre-phase avec l'impulsion électrique de détection (cas correspondant à un flux d'aimant F_{A} de sens / signe opposé à celui du flux magnétique F_{B} engendré par la bobine), l'intensité I_{B}(t) du courant électrique augmente lentement sans champ magnétique extérieur H_{Ext} mais elle augmente rapidement en présence d'un champ magnétique extérieur engendrant un flux magnétique extérieur F_{H} relativement fort et de sens / signe opposé à celui de l'aimant du rotor. On a donc un temps de montée T_{M} pour le courant électrique I_{B}(t) qui devient court en présence d'un champ magnétique extérieur H_{EXT} relativement fort dans les conditions susmentionnées, car la montée du courant électrique I_{B}(t) dans ces conditions passe de 'lente' à 'rapide'. Le procédé de détection d'un champ magnétique extérieur selon l'invention repose sur ce phénomène physique et sur une mesure du temps de montée T_{M} en connaissance de la position de repos du rotor (information nécessaire pour fournir des impulsions électriques motrices) au moment du déclenchement d'une impulsion électrique de détection dont on connaît évidemment la polarité (à savoir s'il s'agit d'une impulsion électrique positive ou négative, cette information étant donnée lors de la génération de toute impulsion électrique).

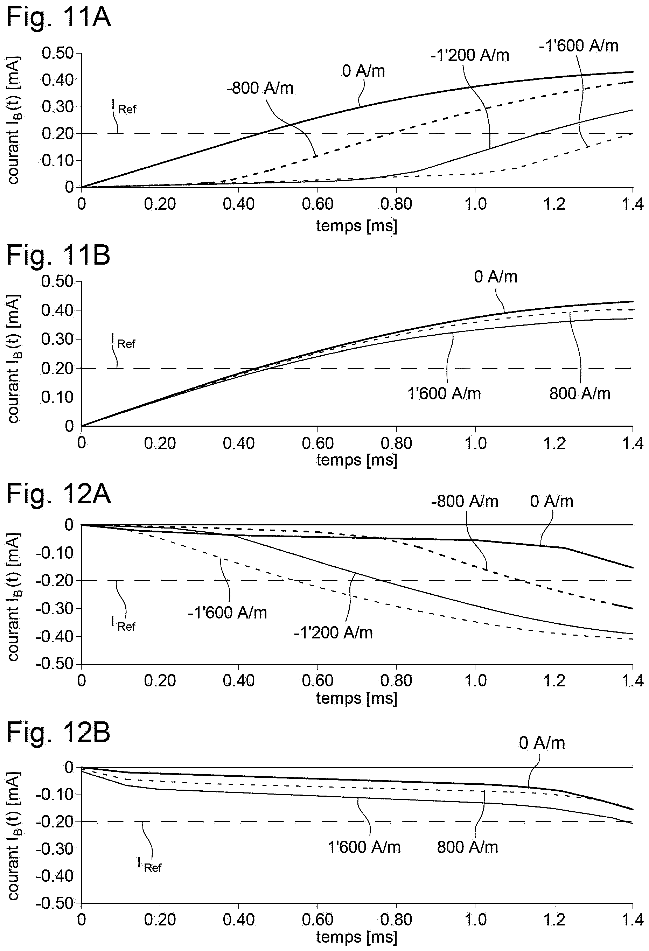

Aux Figures 11A et 11B sont données des courbes de l'évolution temporelle du courant électrique I_{B}(t) dans la bobine avec l'aimant permanent dans sa position de repos positive pour des impulsions électriques en phase, donc positives, et un champ magnétique extérieur respectivement négatif et positif pour diverses intensités du champ magnétique extérieur. On observe à la Fig. 11A le phénomène physique que nous venons d'exposer pour un champ magnétique extérieur négatif. La Fig. 11B montre qu'il n'y a quasi pas de variation dans l'évolution temporelle du courant électrique dans la bobine, qui demeure rapide, lorsque le champ magnétique extérieur a un même sens / signe que la position de repos de l'aimant permanent, c'est-à-dire lorsque le flux magnétique extérieur F_{H} et le flux magnétique F_{A} de l'aimant dans les deux isthmes ont un même sens, et donc un même signe. Aux Figures 12A et 12B sont données des courbes de l'évolution temporelle du courant électrique I_{B}(t) dans la bobine avec l'aimant permanent aussi dans sa position de repos positive mais pour des impulsions électriques en contre-phase, donc négatives, et un champ magnétique extérieur respectivement négatif et positif pour diverses intensités du champ magnétique extérieur. On observe à la Fig. 12A le phénomène physique que nous venons d'exposer. La Fig. 12B montre à nouveau qu'il y a peu de variation dans l'évolution temporelle du courant électrique I_{B}(t) dans la bobine, qui demeure lente, lorsque le champ magnétique extérieur a un même signe que la position de repos de l'aimant permanent.

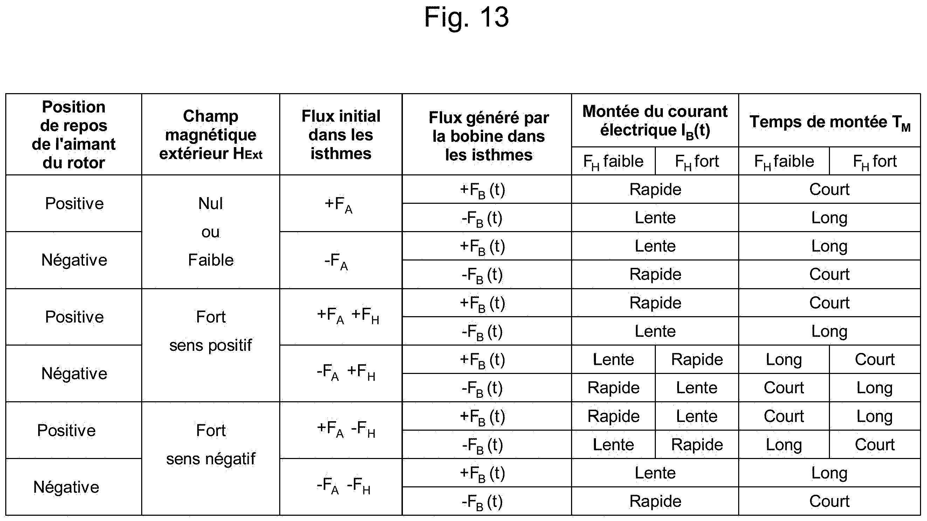

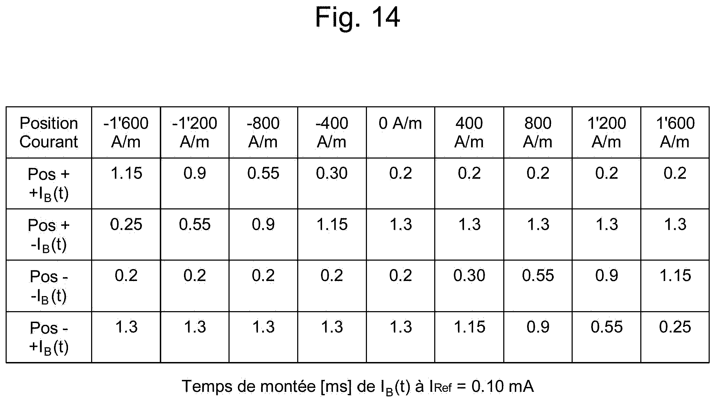

Le tableau de la Figure 13 récapitule les observations effectuées et constations particulières en lien avec la montée du courant électrique I_{B}(t) dans la bobine 18 et le temps de montée T_{M} au courant de référence I_{Ref} à l'enclenchement d'une impulsion électrique de détection. Le tableau de la Figure 14 redonne l'enseignement de la Fig.13 sous une autre forme et de manière chiffrée, avec diverses valeurs du champ magnétique extérieur. On peut donner une explication physique à la variation ou non du temps de montée T_{M} en fonction des conditions initiales pour la position de repos de l'aimant permanent et la polarité des impulsions électriques de détection lorsqu'on se trouve ou non en présence d'un certain champ magnétique extérieur relativement fort et plus généralement lorsque l'intensité de ce champ magnétique extérieur augmente progressivement. L'équation du courant électrique I_{B}(t) dans la bobine en fonction d'une tension Vs appliquée à la bobine, laquelle est montée sur le circuit magnétique formé par le stator, comprend un deuxième terme qui est lié à la tension induite par une variation du courant électrique. En première approximation, on a l'équation suivante pour le courant électrique : ${V}_{S} = R ⋅ {I}_{B} \left(t\right) + L ⋅ {dI}_{B} \left(t\right) / dt$ où Vs est la tension constante appliquée à la bobine, R est la résistance électrique de la bobine et L est l'inductance de cette bobine.

L'inductance L de la bobine est liée à la perméance magnétique (inverse de la réluctance magnétique) du circuit magnétique qui est défini par le stator et qui comprend un noyau sur lequel est montée la bobine. Or la perméance magnétique du circuit magnétique, formé par le stator pour la bobine, varie en fonction du degré de saturation magnétique des deux isthmes 12a & 12b. Ainsi l'inductance L de la bobine varie aussi en fonction du degré de saturation magnétique des deux isthmes. Plus précisément, lorsque les deux isthmes sont pas ou peu saturés, l'inductance L est relativement grande et lorsque les deux isthmes sont fortement ou totalement saturés, cette l'inductance L est relativement petite. La conséquence qui résulte de l'équation de la tension susmentionnée est la suivante : Pour une tension d'alimentation Vs donnée, lorsque l'inductance L est grande, la variation temporelle du courant électrique dI_{B}(t)/dt est lente, et lorsque l'inductance L est relativement petite, la variation temporelle du courant électrique dI_{B}(t)/dt est alors relativement rapide. Ainsi, avec une inductance L grande, le temps de montée T_{M} du courant électrique I_{B}(t) à un courant de référence I_{Ref} donné est relativement long. Par contre, avec une inductance L petite, le temps de montée T_{M} du courant électrique I_{B}(t) à un courant de référence I_{Ref} donné est relativement court.

Le phénomène physique décrit ci-avant est utilisé dans le cadre de l'invention pour détecter un champ magnétique extérieur H_{Ext}, comme exposé précédemment. Pour comprendre les résultats donnés aux tableaux des Figures 13 et 14, on doit premièrement remarquer que le flux magnétique d'aimant F_{A} dans les isthmes 12a & 12b doit saturer magnétiquement, dans ses deux positions de repos, à un niveau significatif ces deux isthmes. Ceci est généralement le cas dans un moteur horloger à aimant permanent bipolaire, notamment du type Lavet (correspondant à celui représenté sur les Figures et décrit précédemment). Ensuite, le champ magnétique extérieur H_{Ext} détecté doit engendrer un flux magnétique extérieur F_{H} dans les deux isthmes ayant au moins un même ordre de grandeur que le flux magnétique F_{A} de l'aimant permanent, de préférence une intensité supérieure à F_{A}, de manière que la superposition de ces deux flux magnétiques, lorsqu'ils présentent des sens opposés, soit diminue de manière significative la réluctance du circuit magnétique, soit présente un sens du flux magnétique résultant dans les deux isthmes qui est inversé relativement au flux magnétique F_{A} (ce second cas étant préféré). Finalement, la bobine est agencée de sorte à fournir, au moins après un intervalle de temps inférieur à la durée des impulsions électriques de détection, un flux magnétique F_{B}(t) dans les deux isthmes qui est aussi au moins de l'ordre de grandeur du flux magnétique F_{A} de l'aimant, de préférence supérieur à F_{A}. Pratiquement, dans un moteur horloger à aimant permanent bipolaire, pour pouvoir entraîner en rotation le rotor, le flux magnétique F_{B}(t) sature à lui seul fortement les deux isthmes après un certain intervalle de temps initial, comme indiqué par la courbe 46 à la Figure 5.

Les résultats des tableaux 13 et 14 s'expliquent de la manière suivante : En l'absence de flux magnétique extérieur F_{H}, lorsque le courant électrique I_{B}(t) est en phase avec la position de repos de l'aimant permanent (même sens du flux magnétique dans les deux isthmes et donc même signe), ce courant électrique ne fait qu'augmenter la saturation magnétique des deux isthmes qui était initialement déjà saturé à un niveau relativement important. Ainsi, l'inductance L(t) demeure petite durant toute l'impulsion électrique de détection et le temps de montée T_{M} est court. Au contraire, lorsque le courant électrique I_{B}(t) est en contre-phase avec la position de repos de l'aimant permanent (sens opposés des flux magnétiques dans les deux isthmes et donc signes opposés), le flux magnétique F_{B}(t) de la bobine diminue au moins momentanément, dans un intervalle de temps initial de l'impulsion électrique de détection, la saturation magnétique dans les deux isthmes (à noter que la saturation devient généralement à nouveau forte après l'intervalle de temps initial et même plus forte mais avec une inversion du sens du flux magnétique dans les deux isthmes qui est engendrée par le flux magnétique F_{B}(t)). Ainsi, au cours de l'intervalle de temps initial, l'inductance L(t) de la bobine augmente et devient même grande durant un court moment, ce qui a pour conséquence que le temps de montée T_{M} du courant électrique est long. On doit donc considérer l'évolution temporelle de l'inductance et non seulement une situation terminale en fin d'une impulsion électrique pour comprendre les résultats obtenus.

En présence d'un champ magnétique extérieur H_{Ext}, lorsque le flux magnétique extérieur F_{H} a un même sens / signe que le flux magnétique F_{A} de l'aimant permanent, la situation est de fait sensiblement similaire à celle décrite au paragraphe précédent car le champ magnétique extérieur augmente un peu la saturation magnétique initiale due à l'aimant, laquelle est déjà relativement forte. Ainsi, le champ magnétique extérieur H_{Ext} ne change pas de manière significative l'évolution de l'inductance L(t) lors de l'impulsion électrique de détection, tout au plus il introduit un petit retard (déphasage temporel) dans l'augmentation momentanée de l'inductance L(t) lorsque l'aimant permanent et l'impulsion électrique de détection sont en contre-phase, ce qui se traduit par une petite augmentation initiale du courant électrique I_{B}(t) dans la bobine. Par contre, lorsque le flux magnétique extérieur F_{H} a un sens opposé à celui du flux magnétique F_{A} de l'aimant permanent, ce flux magnétique extérieur F_{H} change les conditions initiales concernant la saturation magnétique dans les deux isthmes et/ou le sens initial du flux magnétique total initial dans ces deux isthmes, de sorte que l'évolution temporelle de l'inductance L(t) est modifiée de manière significative pour les deux polarités des impulsions électriques de détection lorsque l'intensité du champ magnétique extérieur H_{Ext} devient suffisamment grande, et ceci au moins dans une plage de valeurs utile pour l'intensité du champ magnétique extérieur.

En particulier, lorsque l'impulsion électrique est en phase avec la position de repos du rotor, un champ magnétique extérieur engendrant un flux magnétique F_{H} dans les deux isthmes avec un sens opposé au flux magnétique F_{A} de l'aimant permanent a pour conséquence que le flux magnétique F_{B}(t) de la bobine va au moins momentanément diminuer la saturation magnétique et ainsi augmenter l'inductance L(t), de sorte que le temps de montée T_{M} va augmenter, et ceci de manière progressive avec l'augmentation de l'intensité du flux magnétique extérieur F_{H} au moins dans une plage de valeurs donnée pour cette intensité entre la valeur nulle et une valeur maximale déterminée. Dans l'exemple donné à la Figure 14, la valeur maximale en question est environ égale à 2'000 A/m. Lorsque l'impulsion électrique est en contre-phase avec la position de repos du rotor, un champ magnétique extérieur engendrant un flux magnétique extérieur F_{H} dans les deux isthmes avec un sens opposé au flux magnétique F_{A} de l'aimant permanent a pour conséquence que le flux magnétique F_{B}(t) de la bobine va au moins amoindrir et même annuler, lorsque le flux magnétique extérieur F_{H} a une assez forte intensité, la diminution de la saturation magnétique dans les isthmes qui intervient en l'absence du flux magnétique extérieur F_{H} et ainsi diminuer l'inductance L(t) au moins momentanément au cours de l'impulsion électrique de détection, de sorte que le temps de montée T_{M} va diminuer, et ceci de manière progressive avec l'augmentation de l'intensité du flux magnétique extérieur F_{H} au moins dans une plage de valeurs donnée pour cette intensité.

Une constatation importante se dégage de l'enseignement donné ci-avant, à savoir que, lorsque le rotor / l'aimant permanent est dans la position de repos négative, seul un champ magnétique extérieur engendrant un flux magnétique extérieur F_{H} positif (+F_{H}), dans une plage de valeurs utile de son intensité, peut être détecté aisément sur la base du temps de montée T_{M}, et que, lorsque le rotor / l'aimant permanent est dans la position de repos positive, seul un champ magnétique extérieur engendrant un flux magnétique extérieur F_{H} négatif (-F_{H}), dans une plage de valeurs utile de son intensité, peut être détecté aisément sur la base du temps de montée T_{M}.

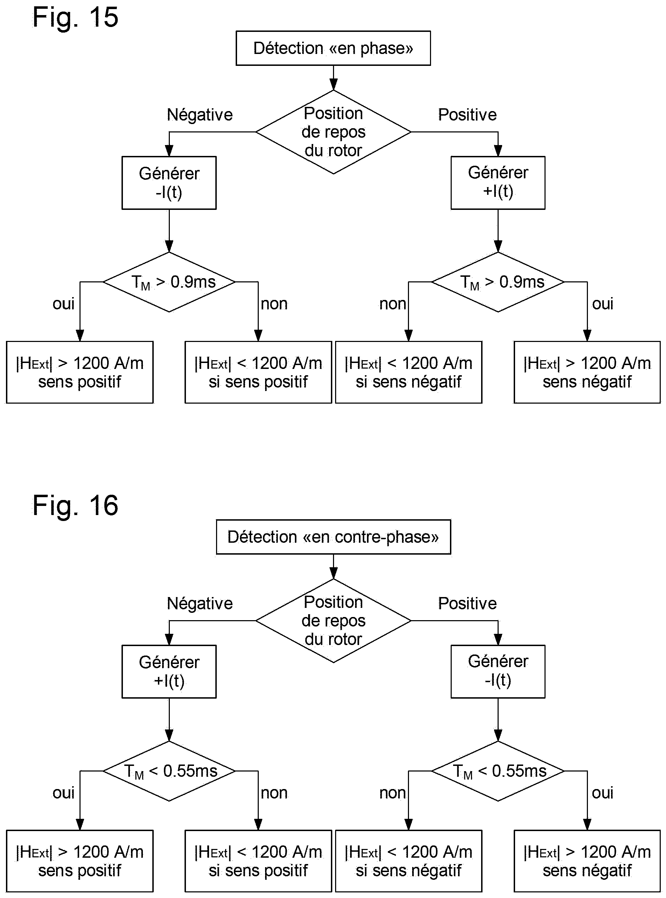

Pour exploiter les résultats et constations donnés précédemment, le circuit de commande 20 du moteur pas-à-pas, en particulier le circuit 24 de détection d'un champ magnétique extérieur et plus spécifiquement le circuit 36 de traitement du temps de montée mesuré, sont agencés, dans un mode de réalisation principal, de manière à permettre la mise en œuvre d'un procédé de détection d'un champ magnétique extérieur, dont deux modes principaux sont donnés sous forme de diagramme respectivement aux Figures 15 et 16.

La Figure 15 donne les étapes d'une variante d'un premier mode de mise en œuvre d'un procédé de détection d'un champ magnétique extérieur dans lequel l'impulsion électrique de détection est en phase avec la position de repos du rotor, alors que la Figure 16 donne les étapes d'une variante d'un deuxième mode de mise en œuvre du procédé de détection selon l'invention, dans lequel l'impulsion électrique de détection est en contre-phase avec la position de repos du rotor.

Dans le premier mode de détection « en phase », le procédé de détection détermine premièrement la position de repos de l'aimant permanent. Cette information est généralement connue dans les circuits de commande d'un moteur pas-à-pas à aimant bipolaire, car les impulsions électriques motrices doivent être en phase avec la position de repos de l'aimant permanent. Ensuite, on engendre une impulsion électrique de détection (impulsion de détection) en phase, ayant par exemple une durée entre 1.5 ms et 2.0 ms. Dès le début de l'impulsion de détection, le circuit de mesure du courant I_{B}(t) est actif et le compteur temporel 32 est déclenché au début de l'impulsion de détection, de sorte à pouvoir mesurer le temps de montée T_{M} du courant I_{B}(t) jusqu'à une valeur sensiblement égale à celle d'un courant de référence I_{Ref} (qui a une valeur de référence absolue donnée). Le courant de référence a dans la variante décrite une valeur de référence absolue sélectionnée entre 0.10 mA et 0.30 mA, de préférence entre 0.15 mA et 0.25 mA, par exemple 0.20 mA. Une fois le temps de montée mesuré, il est prévu de traiter cette information pour détecter la présence d'un certain champ magnétique extérieur H_{Ext}, plus exactement d'un champ magnétique extérieur qui engendre dans les isthmes un certain flux magnétique extérieur F_{H} (lequel passe donc au travers des isthmes) ayant un sens donné, à savoir un sens positif lorsque l'impulsion de détection a une polarité négative et un sens négatif lorsque la polarité de l'impulsion de détection est positive.

Diverses variantes sont possibles pour le traitement du temps de montée T_{M} par le circuit de traitement 36. Dans la variante donnée à la Figure 15, le circuit de traitement cherche à détecter un champ magnétique extérieur qui engendre dans les isthmes 12a & 12b du stator 4 un flux magnétique F_{H} ayant au moins une certaine intensité.

Dans le tableau de la Figure 14 ont été données des valeurs pour un champ magnétique extérieur H_{Ext} dans le cas particulier d'un champ magnétique extérieur se propageant parallèlement au plan du stator et globalement de manière perpendiculaire à la direction d'alignement des deux isthmes. Dans ce cas particulier, pour déterminer les flux magnétiques F_{H} correspondants, lesquels sont déterminants pour le procédé de détection selon l'invention, la courbe 50 de la Figure 8 donne la relation entre ces deux variables physiques pour l'exemple en question. Pour détecter un champ magnétique extérieur d'une relativement grande intensité, équivalent au niveau du flux dans les isthmes à un champ magnétique extérieur selon le cas particulier susmentionné ayant plus de 1'000 A/m, plus précisément au moins une valeur de 1'200 A/m en relation avec les valeurs du tableau de la Figure 14, le circuit de traitement 36 détermine si le temps de montée T_{M} est supérieur à une première durée de référence, soit 0.9 ms dans l'exemple considéré. Si tel est le cas, ce premier mode de détection conclut, pour la position de repos positive, à la présence d'un champ magnétique extérieur négatif ayant une intensité supérieure à une première valeur minimale, soit au moins une intensité de 1'200 A/m pour le cas particulier mentionné ou pour un champ magnétique extérieur équivalent en relation avec le flux magnétique extérieur engendré dans les deux isthmes du stator, et, pour la position de repos négative, à la présence d'un champ magnétique extérieur positif ayant une intensité supérieure à une deuxième valeur minimale, soit au moins une intensité de 1'200 A/m pour le cas particulier mentionné ou pour un champ magnétique extérieur équivalent. Si tel n'est pas le cas, ce premier mode de détection conclut au contraire pour la position de repos positive et la position de repos négative.

Dans le deuxième mode de détection « en contre-phase », le procédé de détection détermine également premièrement la position de repos de l'aimant permanent / du rotor. Ensuite, on engendre une impulsion de détection en contre-phase, ayant par exemple une durée entre 1.5 ms et 2.0 ms. Le temps de montée T_{M} du courant I_{B}(t) jusqu'au courant de référence I_{Ref} est mesuré. Une fois le temps de montée mesuré, cette information est traitée pour détecter la présence d'un certain champ magnétique extérieur H_{Ext}, plus exactement d'un champ magnétique extérieur qui engendre dans les isthmes un flux magnétique extérieur F_{H} ayant un sens donné, à savoir un sens positif lorsque l'impulsion de détection a une polarité négative et un sens négatif lorsque la polarité de l'impulsion de détection est positive (comme dans le premier mode de détection « en phase »). Dans la variante donnée à la Figure 16, le circuit de traitement cherche à détecter un champ magnétique extérieur qui engendre dans les isthmes 12a & 12b du stator 4 un flux magnétique F_{H} ayant au moins une certaine intensité, sensiblement égale à celle sélectionnée pour le premier mode de détection. A cet effet, le circuit de traitement 36 détermine si le temps de montée T_{M} est inférieur à une deuxième durée de référence, soit 0.55 ms dans l'exemple considéré. Si tel est le cas, ce deuxième mode de détection conclut de la même manière que le premier mode de détection ; soit, pour la position de repos positive, à la présence d'un champ magnétique extérieur négatif ayant une intensité supérieure à une première valeur minimale, égale à une intensité de 1'200 A/m pour le cas particulier mentionné ou pour un champ magnétique extérieur équivalent en relation avec le flux magnétique extérieur engendré dans les deux isthmes du stator ; soit, pour la position de repos négative, à la présence d'un champ magnétique extérieur positif ayant une intensité supérieure à une deuxième valeur minimale, égale à une intensité de 1'200 A/m pour le cas particulier mentionné ou pour un champ magnétique extérieur équivalent. Si tel n'est pas le cas, ce deuxième mode de détection conclut au contraire pour la position de repos positive et la position de repos négative.

On constate donc, comme déjà évoqué, qu'en l'absence de connaissance quant au sens du flux magnétique extérieur dans les isthmes du stator, un procédé de détection d'un champ magnétique extérieur, engendrant dans les isthmes un flux magnétique extérieur d'une certaine intensité, comprend de préférence, pour permettre la détection de ce champ magnétique extérieur quelle que soit son sens dans ces isthmes, une première phase, selon le premier mode de détection ou le deuxième mode de détection, avec le rotor dans sa position de repos positive ou négative et une deuxième phase, également selon le premier mode de détection ou le deuxième mode de détection, avec le rotor respectivement dans sa position de repos négative ou positive.

De manière générale, le circuit 36 de traitement du temps de montée T_{M} est agencé pour pouvoir déterminer, au moins dans une plage de valeurs utile, soit approximativement une valeur / intensité d'un champ magnétique extérieur ou de son flux traversant, le cas échéant, les deux isthmes du stator selon une direction perpendiculaire à la direction d'alignement de ces deux isthmes, soit si la valeur / intensité dudit champ magnétique extérieur ou de son flux traversant, le cas échéant, les deux isthmes selon ladite direction est supérieure à une valeur de référence. Les variantes données aux Figures 15 et 16 concernent le second cas susmentionné. Pour le premier cas susmentionné, le tableau de la Figure 14 peut être utilisé, soit en effectuant des approximations linéaires entre deux valeurs du tableau pour définir des valeurs intermédiaires, soit en déterminant une courbe ou une fonction donnant les valeurs du champ magnétique extérieur H_{Ext} en fonction du temps de montée T_{M}.

Dans une variante particulière, le circuit de traitement du temps de montée est agencé pour pouvoir déterminer, au moins dans la plage de valeurs utile, si la valeur dudit champ magnétique extérieur ou de son flux traversant, le cas échéant, les deux isthmes selon la direction susmentionnée est situé dans une plage de valeurs spécifique parmi une pluralité de plages de valeurs spécifiques données qui se succèdent.

Dans les modes de détection décrits précédemment, le circuit de traitement du temps de montée est agencé pour pouvoir aussi déterminer le sens du champ magnétique extérieur traversant, le cas échéant, les deux isthmes selon la direction susmentionnée.

Dans une première variante avantageuse, le circuit de détection d'un champ magnétique extérieur est agencé de manière à générer une ou plusieurs impulsion(s) de détection en contre-phase relativement à la position de repos du rotor, à savoir une impulsion électrique négative lorsque le rotor est dans la position de repos positive et une impulsion électrique positive lorsque le rotor est dans la position de repos négative, de sorte que la détection du champ magnétique extérieur ne puisse pas engendrer une avance d'un pas du rotor, étant donné que les impulsions électriques en contre-phase ne sont pas des impulsions motrices.

Dans une deuxième variante avantageuse, le circuit de détection d'un champ magnétique extérieur est agencé de manière à générer une ou plusieurs impulsion(s) de détection en phase relativement à la position de repos du rotor, à savoir une impulsion électrique positive lorsque le rotor est dans la position de repos positive et une impulsion électrique négative lorsque le rotor est dans la position de repos négative. Il est prévu que l'impulsion électrique en phase a une durée sélectionnée de manière à permettre la détection du champ magnétique extérieur, cette durée sélectionnée étant assez courte pour que le moteur pas-à-pas ne puisse pas avancer d'un pas.

## Revendications

1. Circuit électronique de commande (20) d'un moteur (2) du type pas-à-pas, ce moteur comprenant un rotor (3) muni d'un aimant permanent (6), qui est bipolaire et présente un axe d'aimantation perpendiculaire à l'axe de rotation (7) de ce rotor, et un stator (4) qui définit un circuit magnétique, une ouverture (8) formant un logement pour l'aimant permanent, deux isthmes (12a & 12b) en périphérie de l'ouverture et diamétralement opposés selon une première direction (14) perpendiculaire à l'axe de rotation, et deux positions de repos pour le rotor dans lesquelles l'aimant permanent est orienté selon une deuxième direction (16), décalée angulairement relativement à la première direction, respectivement dans les deux sens ; l'aimant permanent générant dans les deux positions de repos un premier flux magnétique (F_{A}) traversant les deux isthmes respectivement dans les deux sens, une première position de repos correspondant à un sens positif et la seconde position de repos correspondant à un sens négatif du premier flux magnétique ; le moteur comprenant en outre une bobine (18) montée sur le circuit magnétique de manière à pouvoir générer, lorsqu'elle est alimentée par une impulsion électrique positive (+Is(t)) ou une impulsion électrique négative (-I_{B}(t)), un deuxième flux magnétique traversant les deux isthmes respectivement dans ledit sens positif ou ledit sens négatif ; le circuit électronique de commande comprenant des moyens de détermination de la position du rotor au repos, parmi lesdites première et seconde positions de repos, et un générateur (22) d'impulsions électriques agencé pour pouvoir fournir sélectivement à la bobine des impulsions électriques positives et négatives ; **caractérisé en ce que** le circuit électronique de commande (20) comprend un circuit (24) de détection d'un champ magnétique extérieur formé par un circuit (26) de mesure dudit courant électrique, un circuit (28) de comparaison du courant électrique mesuré avec un courant de référence (I_{Ref}), un circuit (32) de mesure du temps agencé pour mesurer un temps de montée (T_{M}) entre le déclenchement d'une desdites impulsions électriques et l'instant suivant où le courant électrique circulant dans la bobine atteint le courant de référence, et un circuit (36) de traitement du temps de montée, ce circuit de traitement étant agencé pour pouvoir déterminer si le temps de montée mesuré indique la présence d'un champ magnétique extérieur (H_{Ext}) qui traverse les deux isthmes.

2. Circuit électronique de commande selon la revendication 1, **caractérisé en ce que** les deux isthmes du moteur sont agencés de manière que le premier flux magnétique et le deuxième flux magnétique traversent les deux isthmes principalement selon une troisième direction (40) qui est orthogonale à la première direction.

3. Circuit électronique de commande selon la revendication 1 ou 2, **caractérisé en ce que** le circuit (32) de traitement du temps de montée (T_{M}) est agencé pour pouvoir déterminer, au moins dans une plage de valeurs utile, soit approximativement une intensité du champ magnétique extérieur ou du flux de ce champ magnétique extérieur traversant, le cas échéant, les deux isthmes , soit si l'intensité du champ magnétique extérieur ou de son flux traversant, le cas échéant, les deux isthmes est supérieure à une valeur minimale donnée.

4. Circuit électronique de commande selon la revendication 3, **caractérisé en ce que** le circuit (32) de traitement du temps de montée (T_{M}) est agencé pour pouvoir déterminer, au moins dans la plage de valeurs utile, si l'intensité dudit champ magnétique extérieur ou de son flux traversant, le cas échéant, les deux isthmes est dans une plage de valeurs spécifique parmi une pluralité de plages de valeurs spécifiques données qui se succèdent.

5. Circuit électronique de commande selon une quelconque des revendications précédentes, **caractérisé en ce que** le circuit (24) de détection d'un champ magnétique extérieur est agencé de manière à permettre de déterminer le sens de ce champ magnétique extérieur traversant, le cas échéant, les deux isthmes.

6. Circuit électronique de commande selon une quelconque des revendications précédentes, **caractérisé en ce qu'**il est agencé, pour détecter la présence d'un champ magnétique extérieur, de manière à générer une impulsion électrique en contre-phase relativement à la position de repos du rotor, à savoir une impulsion électrique négative lorsque le rotor est dans la position de repos positive et une impulsion électrique positive lorsque le rotor est dans la position de repos négative, de sorte que la détection du champ magnétique extérieur ne puisse pas engendrer une avance d'un pas du rotor.

7. Circuit électronique de commande selon une quelconque des revendications 1 à 5, **caractérisé en ce qu'**il est agencé, pour détecter la présence d'un champ magnétique extérieur, de manière à générer une impulsion électrique en phase relativement à la position de repos du rotor, à savoir une impulsion électrique positive lorsque le rotor est dans la position de repos positive et une impulsion électrique négative lorsque le rotor est dans la position de repos négative ; et **en ce que** ladite impulsion en phase a une durée sélectionnée de manière à permettre la détection du champ magnétique extérieur, la durée sélectionnée ne permettant pas au moteur pas-à-pas d'avancer d'un pas.

8. Mouvement électromécanique comprenant un moteur (2) du type pas-à-pas et un circuit électronique de commande (20) selon une quelconque des revendications précédentes, ce moteur comprenant un rotor (3) muni d'un aimant permanent bipolaire (6), présentant un axe d'aimantation perpendiculaire à l'axe de rotation (7) de ce rotor, et un stator (4) qui définit un circuit magnétique, une ouverture (8) formant un logement pour l'aimant permanent, deux isthmes (12a & 12b) en périphérie de l'ouverture et diamétralement opposés selon une première direction (14) perpendiculaire à l'axe de rotation, et deux positions de repos pour le rotor dans lesquelles l'aimant permanent est orienté selon une deuxième direction (16), décalée angulairement relativement à la première direction, respectivement dans les deux sens ; l'aimant permanent générant dans les deux positions de repos un premier flux magnétique (F_{A}) traversant les deux isthmes respectivement dans les deux sens, une première position de repos correspondant à un sens positif et la seconde position de repos correspondant à un sens négatif du premier flux magnétique ; le moteur comprenant en outre une bobine (18) montée sur le circuit magnétique de manière à pouvoir générer, lorsqu'elle est alimentée par une impulsion électrique positive (+Is(t)) ou une impulsion électrique négative (-I_{B}(t)), un deuxième flux magnétique traversant les deux isthmes respectivement dans ledit sens positif ou ledit sens négatif.

9. Montre **caractérisée en ce qu'**elle comprend un mouvement électromécanique selon la revendication 8.

10. Procédé de détection d'un champ magnétique extérieur dans lequel se trouve un moteur (2) du type pas-à-pas, notamment un moteur horloger, commandé par un circuit électronique de commande (20) selon une quelconque des revendications 1 à 7, comprenant les étapes suivantes :
- Déterminer la position de repos du rotor (3), à savoir si le rotor est dans sa position de repos positive ou dans sa position de repos négative ;
- Générer une impulsion électrique de détection (I_{B}(t)) ;
- Si la polarité de l'impulsion électrique de détection est en phase avec la position de repos du rotor, déterminer si ledit temps de montée est supérieur à une première durée de référence ; et si la polarité de l'impulsion électrique de détection est en contre-phase avec la position de repos du rotor, déterminer si ledit temps de montée est inférieur à une deuxième durée de référence ;
- Si la position de repos du rotor est négative et si le temps de montée remplit une des deux conditions de l'étape précédente, conclure à la présence d'un champ magnétique extérieur (H_{Ext}) ayant un sens positif et une intensité supérieure à une première valeur minimale donnée ; et si la position de repos du rotor est positive et si le temps de montée remplit une des deux conditions de l'étape précédente, conclure à la présence d'un champ magnétique extérieur ayant un sens négatif et une intensité supérieure à une deuxième valeur minimale donnée.

11. Procédé de détection selon la revendication 10, **caractérisé en ce que** qu'il comprend une première phase, dans laquelle lesdites étapes sont effectuées lorsque le rotor est dans sa position de repos positive ou négative, et une deuxième phase intervenant après que le moteur ait effectué un pas moteur et dans laquelle lesdites étapes sont à nouveau effectuées alors que le rotor est respectivement dans sa position de repos négative ou positive.

## Patentansprüche

1. Elektronische Steuerschaltung (20) eines Schrittmotors (2), wobei dieser Motor einen Rotor (3) mit einem Permanentmagneten (6), der bipolar ist und eine Magnetisierungsachse aufweist, die senkrecht zur Drehachse (7) des Rotors verläuft, und einen Stator (4) umfasst, der einen magnetischen Kreis, eine Öffnung (8), die eine Aufnahme für den Permanentmagneten bildet, zwei Stege (12a & 12b), die am Umfang der Öffnung angeordnet sind und sich gemäß einer ersten Richtung (14), die senkrecht zur Drehachse verläuft, diametral gegenüberliegen, sowie zwei Ruhelagen für den Rotor definiert, in denen der Permanentmagnet gemäß einer zweiten Richtung (16) ausgerichtet ist, die gegenüber der ersten Richtung jeweils in entgegengesetztem Sinn winkelversetzt ist; wobei der Permanentmagnet in den beiden Ruhelagen einen ersten magnetischen Fluss (F_{A}) erzeugt, der die beiden Stege je nach Ruhelage in einem von zwei entgegengesetzten Sinnen durchsetzt, wobei eine erste Ruhelage einer positiven Flussrichtung und die zweite Ruhelage einer negativen Flussrichtung des ersten magnetischen Flusses entspricht; wobei der Motor ferner eine Spule (18) umfasst, die an dem magnetischen Kreis so angeordnet ist, dass sie, wenn sie mit einem positiven elektrischen Impuls (+I_{B}(t)) oder einem negativen elektrischen Impuls (-I_{B}(t)) gespeist wird, einen zweiten magnetischen Fluss erzeugen kann, der die beiden Stege entsprechend in der genannten positiven bzw. der genannten negativen Flussrichtung durchsetzt; wobei die elektronische Steuerschaltung Mittel zur Bestimmung der Ruhelage des Rotors unter der genannten ersten und zweiten Ruhelage sowie einen Impulsgenerator (22) umfasst, der dazu eingerichtet ist, der Spule wahlweise positive und negative elektrische Impulse zuzuführen; **dadurch gekennzeichnet, dass** die elektronische Steuerschaltung (20) eine Schaltung (24) zur Erfassung eines äußeren Magnetfelds umfasst, die durch eine Strommessschaltung (26) zur Messung des genannten elektrischen Stroms, eine Vergleichsschaltung (28) zum Vergleichen des gemessenen elektrischen Stroms mit einem Referenzstrom (I_{Ref}), eine Zeitmessschaltung (32), die dazu eingerichtet ist, eine Anstiegszeit (T_{M}) zwischen dem Auslösen eines der genannten elektrischen Impulse und dem darauffolgenden Zeitpunkt zu messen, zu dem der in der Spule fließende elektrische Strom den Referenzstrom erreicht, und eine Schaltung (36) zur Verarbeitung der Anstiegszeit gebildet ist, wobei die Verarbeitungsschaltung dazu eingerichtet ist, zu bestimmen, ob die gemessene Anstiegszeit das Vorhandensein eines äußeren Magnetfelds (H_{Ext}) anzeigt, das die beiden Stege durchsetzt.

2. Elektronische Steuerschaltung nach Anspruch 1, **dadurch gekennzeichnet, dass** die beiden Stege des Motors so angeordnet sind, dass der erste magnetische Fluss und der zweite magnetische Fluss die beiden Stege überwiegend in einer dritten Richtung (40) durchsetzen, die orthogonal zur ersten Richtung ist.

3. Elektronische Steuerschaltung nach Anspruch 1 oder 2, **dadurch gekennzeichnet, dass** die Schaltung (32) zur Verarbeitung der Anstiegszeit (T_{M}) dazu eingerichtet ist, zumindest in einem nutzbaren Wertebereich entweder näherungsweise die Intensität des äußeren Magnetfelds oder den magnetischen Fluss dieses äußeren Magnetfelds, der gegebenenfalls die beiden Stege durchsetzt, zu bestimmen oder zu bestimmen, ob die Intensität des äußeren Magnetfelds oder dessen magnetischer Fluss, der gegebenenfalls die beiden Stege durchsetzt, größer als ein vorgegebener Mindestwert ist.

4. Elektronische Steuerschaltung nach Anspruch 3, **dadurch gekennzeichnet, dass** die Schaltung (32) zur Verarbeitung der Anstiegszeit (T_{M}) dazu eingerichtet ist, zumindest in dem nutzbaren Wertebereich zu bestimmen, ob die Intensität des genannten äußeren Magnetfelds oder dessen magnetischer Fluss, der gegebenenfalls die beiden Stege durchsetzt, in einem bestimmten Wertebereich aus einer Vielzahl vorgegebener aufeinanderfolgender bestimmter Wertebereiche liegt.

5. Elektronische Steuerschaltung nach einem der vorhergehenden Ansprüche, **dadurch gekennzeichnet, dass** die Schaltung (24) zur Erfassung eines äußeren Magnetfelds dazu eingerichtet ist, die Richtung dieses äußeren Magnetfelds zu bestimmen, das gegebenenfalls die beiden Stege durchsetzt.

6. Elektronische Steuerschaltung nach einem der vorhergehenden Ansprüche, **dadurch gekennzeichnet, dass** sie zur Erfassung des Vorhandenseins eines äußeren Magnetfelds dazu eingerichtet ist, einen in Bezug auf die Ruhelage des Rotors gegenphasigen elektrischen Impuls zu erzeugen, nämlich einen negativen elektrischen Impuls, wenn sich der Rotor in der positiven Ruhelage befindet, und einen positiven elektrischen Impuls, wenn sich der Rotor in der negativen Ruhelage befindet, sodass die Erfassung des äußeren Magnetfelds kein Weiterschalten des Rotors um einen Schritt bewirken kann.

7. Elektronische Steuerschaltung nach einem der Ansprüche 1 bis 5, **dadurch gekennzeichnet, dass** sie zur Erfassung des Vorhandenseins eines äußeren Magnetfelds dazu eingerichtet ist, einen in Bezug auf die Ruhelage des Rotors gleichphasigen elektrischen Impuls zu erzeugen, nämlich einen positiven elektrischen Impuls, wenn sich der Rotor in der positiven Ruhelage befindet, und einen negativen elektrischen Impuls, wenn sich der Rotor in der negativen Ruhelage befindet; und dass der genannte gleichphasige Impuls eine so gewählte Dauer aufweist, dass die Erfassung des äußeren Magnetfelds ermöglicht wird, wobei die gewählte Dauer kein Weiterschalten des Schrittmotors um einen Schritt zulässt.

8. Elektromechanisches Uhrwerk, umfassend einen Schrittmotor (2) und eine elektronische Steuerschaltung (20) nach einem der vorhergehenden Ansprüche, wobei dieser Motor einen Rotor (3) mit einem bipolaren Permanentmagneten (6), der eine senkrecht zur Drehachse (7) des Rotors verlaufende Magnetisierungsachse aufweist, und einen Stator (4) umfasst, der einen magnetischen Kreis, eine Öffnung (8), die eine Aufnahme für den Permanentmagneten bildet, zwei Stege (12a & 12b), die am Umfang der Öffnung angeordnet sind und sich gemäß einer ersten Richtung (14), die senkrecht zur Drehachse verläuft, diametral gegenüberliegen, sowie zwei Ruhelagen für den Rotor definiert, in denen der Permanentmagnet gemäß einer zweiten Richtung (16) ausgerichtet ist, die gegenüber der ersten Richtung jeweils in entgegengesetztem Sinn winkelversetzt ist; wobei der Permanentmagnet in den beiden Ruhelagen einen ersten magnetischen Fluss (F_{A}) erzeugt, der die beiden Stege je nach Ruhelage in einem von zwei entgegengesetzten Sinnen durchsetzt, wobei eine erste Ruhelage einer positiven Flussrichtung und die zweite Ruhelage einer negativen Flussrichtung des ersten magnetischen Flusses entspricht; wobei der Motor ferner eine Spule (18) umfasst, die an dem magnetischen Kreis so angeordnet ist, dass sie, wenn sie mit einem positiven elektrischen Impuls (+I_{B}(t)) oder einem negativen elektrischen Impuls (-I_{B}(t)) gespeist wird, einen zweiten magnetischen Fluss erzeugen kann, der die beiden Stege entsprechend in der genannten positiven bzw. der genannten negativen Flussrichtung durchsetzt.

9. Uhr, **dadurch gekennzeichnet, dass** sie ein elektromechanisches Uhrwerk nach Anspruch 8 umfasst.

10. Verfahren zur Erfassung eines äußeren Magnetfelds, in dem sich ein Schrittmotor (2), insbesondere ein Uhrwerkmotor, befindet, der durch eine elektronische Steuerschaltung (20) nach einem der Ansprüche 1 bis 7 gesteuert wird, wobei das Verfahren die folgenden Schritte umfasst:
- Bestimmen der Ruhelage des Rotors (3), nämlich ob sich der Rotor in seiner positiven Ruhelage oder in seiner negativen Ruhelage befindet;
- Erzeugen eines elektrischen Detektionsimpulses (I_{B}(t));
- wenn die Polarität des elektrischen Detektionsimpulses mit der Ruhelage des Rotors gleichphasig ist, bestimmen, ob die genannte Anstiegszeit größer als eine erste Referenzdauer ist; und wenn die Polarität des elektrischen Detektionsimpulses in Bezug auf die Ruhelage des Rotors gegenphasig ist, bestimmen, ob die genannte Anstiegszeit kleiner als eine zweite Referenzdauer ist;
- wenn die Ruhelage des Rotors negativ ist und die Anstiegszeit eine der beiden Bedingungen des vorhergehenden Schritts erfüllt, auf das Vorhandensein eines äußeren Magnetfelds (H_{Ext}) mit positiver Feldrichtung und einer Intensität schließen, die größer als ein erster vorgegebener Mindestwert ist; und wenn die Ruhelage des Rotors positiv ist und die Anstiegszeit eine der beiden Bedingungen des vorhergehenden Schritts erfüllt, auf das Vorhandensein eines äußeren Magnetfelds mit negativer Feldrichtung und einer Intensität schließen, die größer als ein zweiter vorgegebener Mindestwert ist.

11. Erfassungsverfahren nach Anspruch 10, **dadurch gekennzeichnet, dass** es eine erste Phase umfasst, in der die genannten Schritte durchgeführt werden, wenn sich der Rotor in seiner positiven bzw. negativen Ruhelage befindet, und eine zweite Phase, die erfolgt, nachdem der Motor einen Motorschritt ausgeführt hat, und in der die genannten Schritte erneut durchgeführt werden, während sich der Rotor entsprechend in seiner negativen bzw. positiven Ruhelage befindet.

## Claims

1. An electronic control circuit (20) of a stepper-type motor (2), this motor comprising a rotor (3) provided with a permanent magnet (6), which is bipolar and has a magnetisation axis perpendicular to the axis of rotation (7) of this rotor, and a stator (4) which defines a magnetic circuit, an opening (8) forming a housing for the permanent magnet, two isthmi (12a & 12b) at the periphery of the opening and diametrically opposed in a first direction (14) perpendicular to the axis of rotation, and two rest positions for the rotor in which the permanent magnet is oriented in a second direction (16), angularly offset from the first direction, respectively in both senses of direction; the permanent magnet generating, in the two rest positions, a first magnetic flux (F_{A}) passing through the two isthmi respectively in both senses of direction, a first rest position corresponding to a positive sense of direction and the second rest position corresponding to a negative sense of direction of the first magnetic flux; the motor further comprising a coil (18) mounted on the magnetic circuit so as to be able to generate, when supplied with a positive electrical pulse (+I_{B}(t)) or a negative electrical pulse (-I_{B}(t)), a second magnetic flux passing through the two isthmi respectively in said positive sense of direction or in said negative sense of direction; the electronic control circuit comprising means for determining the position of the rotor at rest, from among said first and second rest positions, and an electrical pulse generator (22) arranged so as to be able to selectively supply the coil with positive and negative electrical pulses; **characterised in that** electronic control circuit (20) comprises a circuit (24) for detecting an external magnetic field formed by a circuit (26) for measuring said electrical current, a circuit (28) for comparing the measured electrical current with a reference current (I_{Ref}), a time measurement circuit (32) arranged to measure a rise time (T_{M}) between triggering of one of said electrical pulses and the next moment in time when the electrical current flowing in the coil reaches the reference current, and a circuit (36) for processing the rise time, this circuit being arranged to be able to determine whether the measured rise time indicates the presence of an external magnetic field (H_{Ext}) passing through the two isthmi.

2. The electronic control circuit according to claim 1, **characterised in that** the two isthmi of the motor are arranged so that the first magnetic flux and the second magnetic flux pass through the two isthmi primarily according to a third direction (40) which is orthogonal to the first direction.

3. The electronic control circuit according to claim 1 or 2, **characterised in that** the circuit (32) for processing the rise time (T_{M}) is arranged so as to be able to determine, at least within a useful range of values, either approximately a strength of the external magnetic field or of the flux of this external magnetic field passing, where appropriate, through the two isthmi, or whether the strength of the external magnetic field or of its flux passing, where appropriate, through the two isthmi is higher than a given minimum value.

4. The electronic control circuit according to claim 3, **characterised in that** the circuit (32) for processing the rise time (T_{M}) is arranged so as to be able to determine, at least within the useful range of values, whether the strength of said external magnetic field or of its flux passing, where appropriate, through the two isthmi is within a specific range of values among a plurality of specific ranges of given values that succeed one another.

5. The electronic control circuit according to any of the preceding claims, **characterised in that** the circuit (24) for detecting an external magnetic field is arranged so as to allow determining the sense of direction of this external magnetic field passing, where appropriate, through the two isthmi.

6. The electronic control circuit according to any of the preceding claims, **characterised in that** it is arranged, for detecting the presence of an external magnetic field, so as to generate an electrical pulse in anti-phase with the rest position of the rotor, namely a negative electrical pulse when the rotor is in the positive rest position and a positive electrical pulse when the rotor is in the negative rest position, so that the detection of the external magnetic field cannot cause an advance of the rotor by one step.

7. The electronic control circuit according to any of claims 1 to 5, **characterised in that** it is arranged, for detecting the presence of an external magnetic field, so as to generate an electrical pulse in-phase with the rest position of the rotor, namely a positive electrical pulse when the rotor is in the positive rest position and a negative electrical pulse when the rotor is in the negative rest position; and **in that** said in-phase pulse has a duration selected so as to enable the detection of the external magnetic field, the selected duration not allowing the stepper motor to advance by one step.

8. An electromechanical movement comprising a stepper-type motor (2) and an electronic control circuit (20) according to any one of the preceding claims, this motor comprising a rotor (3) provided with a bipolar permanent magnet (6), having a magnetisation axis perpendicular to the axis of rotation (7) of this rotor, and a stator (4) which defines a magnetic circuit, an opening (8) forming a housing for the permanent magnet, two isthmi (12a & 12b) at the periphery of the opening and diametrically opposed in a first direction (14) perpendicular to the axis of rotation, and two rest positions for the rotor in which the permanent magnet is oriented in a second direction (16), angularly offset from the first direction, respectively in both senses of direction; the permanent magnet generating in the two rest position a first magnetic flux (F_{A}) passing through the two isthmi in both senses of direction respectively, a first rest position corresponding to a positive sense of direction and the second rest position corresponding to a negative sense of direction of the first magnetic flux; the motor further comprising a coil (18) mounted on the magnetic circuit so as to be able to generate, when supplied with a positive electrical pulse (+I_{B}(t)) or a negative electrical pulse (-I_{B}(t)), a second magnetic flux passing through the two isthmi respectively in said positive sense of direction or in said negative sense of direction.

9. A watch **characterised in that** it comprises an electromechanical movement according to claim 8.

10. A method for detecting an external magnetic field in which a stepper-type motor (2), in particular a timepiece motor, is located, controlled by an electronic control circuit (20) according to any of claims e1 to 7, comprising the following steps of:
- Determining the rest position of the rotor (3), namely whether the rotor is in its positive rest position or in its negative rest position;
- Generating an electrical detection pulse (I_{B}(t));
- If the polarity of the electrical pulse is in phase with the rest position of the rotor, determining whether said rise time is longer than the first reference time; and if the polarity of the electrical detection pulse is in anti-phase with the rest position of the rotor, determining whether said rise time is shorter than a second reference duration;
- If the polarity of the electrical pulse is negative and if the rise time meets one of the two conditions of the previous step, concluding on the presence of an external magnetic field (H_{Ext}) having a positive sense of direction and a strength higher than a given first minimum value; and if the rest position of the rotor is positive and if the rise time meets one of the two conditions of the previous step, concluding on the presence of an external magnetic field having a negative sense of direction and a strength higher than a given second minimum value.

11. The detection method according to claim 10, **characterised in that** it comprises a first phase, in which said steps are performed when the rotor is in its positive or negative rest position, and a second phase taking place after the motor has performed one motor step and in which said steps are performed again while the rotor is respectively in its negative or positive rest position.
